(19) Europäisches Patentamt
European Patent Office
Office européen des brevets

(11) **EP 3 923 011 A1**

(12) **EUROPEAN PATENT APPLICATION**
published in accordance with Art. 153(4) EPC

(43) Date of publication:
**15.12.2021 Bulletin 2021/50**

(51) Int Cl.:
*G01R 33/032* (2006.01)   *G02B 6/02* (2006.01)
*G02B 6/024* (2006.01)   *G02B 6/42* (2006.01)
*G02B 27/14* (2006.01)   *G02B 27/28* (2006.01)

(21) Application number: **19914289.4**

(22) Date of filing: **29.08.2019**

(86) International application number:
**PCT/JP2019/034015**

(87) International publication number:
**WO 2020/161952 (13.08.2020 Gazette 2020/33)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **05.02.2019 JP 2019019105**

(71) Applicants:
• **CITIZEN FINEDEVICE CO., LTD.**
**Minamitsuru-gun, Yamanashi 401-0395 (JP)**
• **Citizen Watch Co., Ltd.**
**Nishitokyo-shi, Tokyo 188-8511 (JP)**
• **Shinshu University**
**Matsumoto-shi, Nagano 390-8621 (JP)**

(72) Inventors:
• **MIYAMOTO, Mitsunori**
**Minamitsuru-gun, Yamanashi 401-0395 (JP)**
• **KUBO, Toshiya**
**Minamitsuru-gun, Yamanashi 401-0395 (JP)**
• **SATO, Toshiroh**
**Nagano-shi, Nagano 380-8553 (JP)**
• **FUJISHIRO, Yuta**
**Nagano-shi, Nagano 380-8553 (JP)**
• **SONEHARA, Makoto**
**Nagano-shi, Nagano 380-8553 (JP)**

(74) Representative: **Ricker, Mathias**
**Wallinger Ricker Schlotter Tostmann
Patent- und Rechtsanwälte Partnerschaft mbB
Zweibrückenstrasse 5-7
80331 München (DE)**

(54) **MAGNETIC FIELD SENSOR DEVICE**

(57) A magnetic field sensor element 30 has a first polarization maintaining fiber 31 separating the linearly polarized light into a first linearly polarized wave propagated along the first slow axis and a second linearly polarized wave propagated along the first phase advance axis faster than the first linearly polarized wave, and propagating the first linearly polarized wave and the second linearly polarized wave, a second polarization maintaining fiber 32 having a second slow axis and a second phase advance axis, and connected to the first polarization maintaining fiber so that the second phase advance axis and the second slow axis are inclined 45 degrees with respect to the first phase advance axis and the first slow axis, a Faraday rotator 33 optically connected to the second polarization maintaining fiber, and shifting a phase of circularly polarized light emitted from the second polarization maintaining fiber in response to magnetic field at which the magnetic field sensor element is disposed, and a mirror element 34 connected to the Faraday rotator, and generating the return light.

FIG. 1

**Description**

TECHNICAL FIELD

The disclosure relates to magnetic field sensor devices.

BACKGROUND

A polarization maintaining fiber (PMF) is known that has enhanced polarization maintaining properties of propagating light by applying non-axisymmetric stresses to a core thereof. A PANDA(Polarization maintaining and Absorption-reducing) fiber, a bow-tie (Bow-tie) fiber, an elliptical jacket (Elliptical Jacket) fiber and etc., are known as polarization maintaining fibers.

Further, magnetic field sensor devices using polarization maintaining fibers are known. For example, a magnetic field sensor device is described in JP 7-111456 in which light is transmitted to a Faraday rotator through a polarization maintaining fiber, by placing a (1/4) wave plate inclined by 45 degrees with respect to the phase advance and slow axes of the a polarization maintaining fiber. In the magnetic field sensor device described in JP 7-111456, the (1/4) wave plate functions as a polarization conversion element for converting linearly polarized light introduced into the polarization maintaining fiber into circularly polarized light.

SUMMARY

However, since the optical axis of the (1/4) wave plate is visually unrecognizable, the optical axis adjustment may be complicated in order to arrange the (1/4) wave plate inclined 45 degrees with respect to the phase advance and slow axes of the polarization maintaining fiber, and therefore it is not easy to conveniently manufacture the magnetic field sensor device described in JP 7-111456.

In one aspect, it is an object of the present disclosure to provide a magnetic field sensor device which may be formed by a single optical path, and be easily manufactured.

A magnetic field sensor device has a light emitter emitting linearly polarized light, a magnetic field sensor element introducing the linearly polarized light as incident light, and deriving return light in response to the incident light, wherein at least a portion thereof is disposed within a predetermined magnetic field, a detection signal generator separating the return light into S polarization component and P polarization component, and outputting a detection signal in response to magnetic field at which the magnetic field sensor element is disposed, based on the S and P polarization components, and an optical branching element transmitting the linearly polarized light to the magnetic field sensor element, and branching the return light to the detection signal generator, wherein the magnetic field sensor element has a first polarization maintaining fiber separating the linearly polarized light into a first linearly polarized wave propagated along the first slow axis and a second linearly polarized wave propagated along the first phase advance axis faster than the first linearly polarized wave, and propagating the first linearly polarized wave and the second linearly polarized wave, a second polarization maintaining fiber having a second slow axis and a second phase advance axis, and connected to the first polarization maintaining fiber so that the second phase advance axis and the second slow axis are inclined 45 degrees with respect to the first phase advance axis and the first slow axis, a Faraday rotator optically connected to the second polarization maintaining fiber, and shifting a phase of circularly polarized light emitted from the second polarization maintaining fiber in response to magnetic field at which the magnetic field sensor element is disposed, and a mirror element connected to the Faraday rotator, and generating the return light.

It is preferable in the magnetic field sensor device that a length of the second polarization maintaining fiber is a length obtained by increasing the length of one quarter of the beat length from the length of 0 times and a positive integer multiple of the beat length of the second polarization maintaining fiber.

It is preferable in the magnetic field sensor device that a length of the second polarization maintaining fiber is a length obtained by decreasing the length of one quarter of the beat length from a length of a positive integer multiple of the beat length of the second polarization maintaining fiber.

It is preferable in the magnetic field sensor device that the first polarization maintaining fiber and the second polarization maintaining fiber are fused connected.

It is preferable in the magnetic field sensor device that each of the first polarization maintaining fiber and the second polarization maintaining fiber is a PANDA fiber.

A magnetic field sensor element has a first polarization maintaining fiber separating the linearly polarized light into a first linearly polarized wave propagated along the first slow axis and a second linearly polarized wave propagated along the first phase advance axis faster than the first linearly polarized wave, and propagating the first linearly polarized wave and the second linearly polarized wave, a second polarization maintaining fiber having a second slow axis and a second phase advance axis, and connected to the first polarization maintaining fiber so that the second phase advance axis and the second slow axis are inclined 45 degrees with respect to the first phase advance axis and the first slow axis, a Faraday rotator optically connected to the second polarization maintaining fiber, and shifting a phase of circularly polarized light emitted from the second polarization maintaining fiber in response to magnetic field at which the magnetic field sensor element is disposed, and a mirror element connected to the Faraday rotator, and generating the return light.

A magnetic field sensor device according to the embodiment may be formed by a single optical path, and be easily manufactured without using (1/4) wave plates.

BRIEF DESCRIPTION OF THE DRAWINGS

Fig. 1 is a block diagram showing a magnetic field sensor device according to an embodiment;
Fig. 2A is a cross-sectional view along the line A-A shown in Fig. 1, and Fig. 2B is a diagram showing a connection relationship between the first and second polarization maintaining fibers shown in Fig. 1;
Fig. 3 is a diagram showing the relationship between the beat length and the polarization state of the incident light having polarization plane inclined 45 degrees with respect to a slow and phase advance axes of the polarization maintaining fiber;
Fig. 4 is a schematic diagram of the Faraday rotator and the mirror element shown in Fig. 1;
Fig. 5 is a diagram for explaining the polarization states of the incident light derived from the magnetic field sensor element and the return light introduced into the magnetic field sensor element; and
Fig. 6 is a circuit block diagram of the signal processor.

DESCRIPTION OF EMBODIMENTS

A preferable embodiment of a magnetic field sensor device according to the disclosure will be described with reference to attached drawings. Note that the technical scope of the disclosure is not limited to such an embodiment but covers the invention and its equivalents, as set forth in the appended claims.

(Configuration and function of the magnetic field sensor device according to the embodiment)

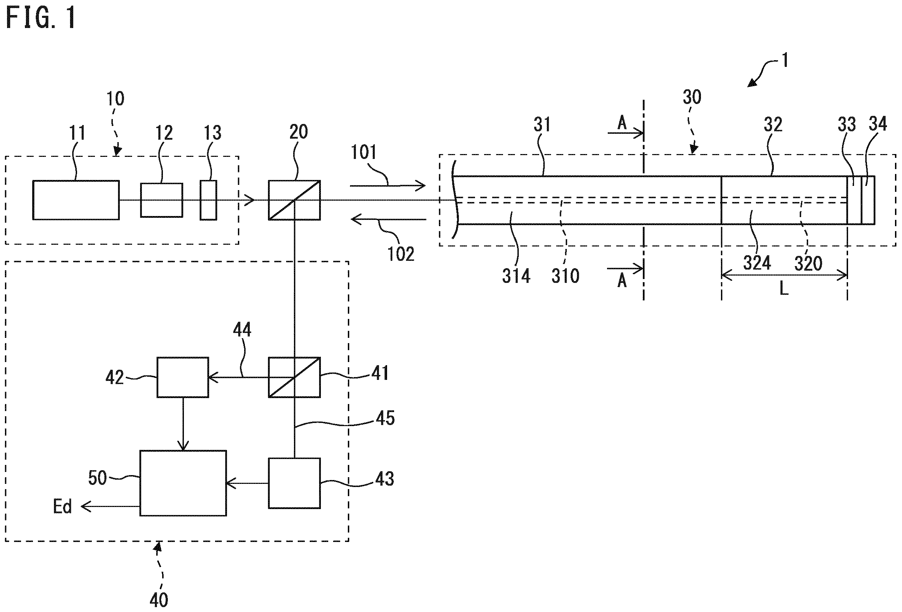

Fig. 1 is a block diagram showing a magnetic field sensor device according to an embodiment.
A magnetic field sensor device 1 has a light emitter 10, an optical branching element 20, a magnetic field sensor element 30 and a detection signal generator 40. The light emitter 10 has a light emitting element 11, an isolator 12 and a polarizer 13.
For example, the light emitting element 11 is a semiconductor laser or a light emitting diode. In particular, a Fabry-Perot laser, superluminescent diode and etc. are preferably used as the light emitting element 11.
The isolator 12 transmits the light incident from the light emitting element 11 to the light branching section 20, and protect the light emitting element 11 without transmitting the light incident from the light branching section 20 to the light emitting element 11. For example, the isolator 12 is a polarization-dependent optical isolator, and may be a polarization-independent optical isolator.
The polarizer 13 is an optical element for polarizing the light emitted by the light emitting element 11 to linearly polarized light, and the types thereof are not limited. The linearly polarized light obtained by the polarizer 13 is incident as incident light 101 to the magnetic field sensor element 30 through the optical branching element 20.
The optical branching element 20 transmits the light emitted from the light emitter 10 to the magnetic field sensor element 30, branches the return light 102 emitted from the magnetic field sensor element 30 to the detection signal generator 40. The directions of transmission and branching may be opposite. For example, the optical branching element 20 is a half mirror, the optical branching element 20 may be an optical coupler for bond and branching optical fibers, a beam splitter for dividing the light, and another optical elements capable of demultiplexing light such as an optical circulator and etc.
The magnetic field sensor element 30 has a first polarization maintaining fiber 31, a second polarization maintaining fiber 32, a Faraday rotator 33 and a mirror element 34, and at least a portion thereof may be disposed within a predetermined magnetic field. A linearly polarized light emitted from light emitter 10 is introduced to the magnetic field sensor element 30 as the incident light 101, and a return light 102 in response to the introduced incident light 101 is derived from the magnetic field sensor element 30.
The detection signal generator 40 has a polarization separating element 41, a first light receiving element 42, a second light receiving element 43 and a signal processor 50, and receives the return light 102 derived from the first polarization maintaining fiber 31. The polarization separating element 41 is a polarizing beam splitter (PBS) such as a prism type, a plane type, a wedge substrate type, an optical waveguide type and etc., and separates the return light 102 derived from the first polarization maintaining fiber 31 into an S polarization component 44 and a P polarization component 45.

For example, each of the first light receiving element 42 and the second light receiving element 43 is a PIN photodiode. The first light receiving element 42 receives the S polarization component 44, and the second light receiving element 43 receives the P polarization component 45. Each of the first and second light receiving elements 42 and 43 photoelectrically converts received light, and outputs an electrical signal corresponding to the amount of the received light.

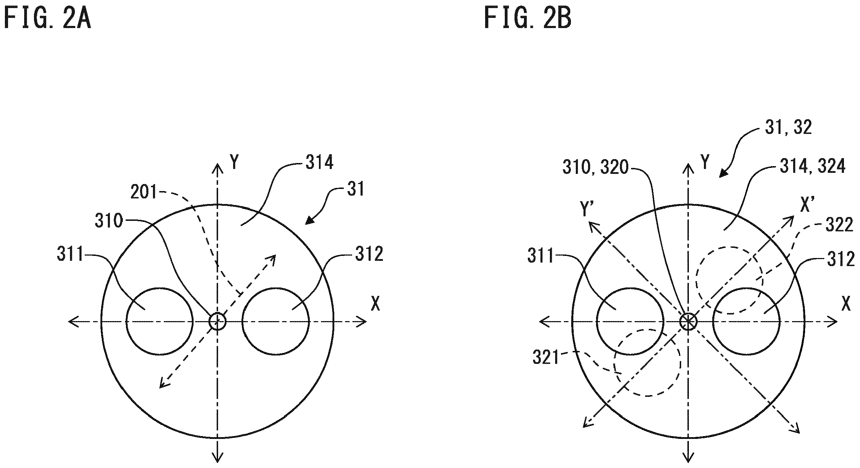

Figure 2A is a cross-sectional view along the line A-A shown in Fig. 1 of the first polarization maintaining fiber 31.

The first polarization maintaining fiber 31 is a PANDA fiber, and has a core 310, a pair of stressing portions 311 and 312, and a clad 314. For example, the core 310 is formed by silicon dioxide adding germanium dioxide ($GeO_2$) so that refractive index thereof is larger than that of the clad 314 formed by silicon oxide ($SiO_2$). For example, each of the pair of stress applying portions 311 and 312 is formed by silicon dioxide adding boron oxide ($B_2O_3$), and tensile stress is imparted in the X axis direction thereof, by shrinking larger than the clad 314 in the cooling step of the spinning of the first polarization maintaining fiber 31.

The first polarization maintaining fiber 31 is disposed so that the polarization plane 201 of the incident light 101 introduced through the optical branching element 20 from the light emitter 10 is inclined 45 degrees with respect to each of the Y axis and X axis i.e., the phase advance axis and the slow axis of the first polarization maintaining fiber 31 (see FIG. 2A). Since the first polarization maintaining fiber 31 is disposed so that the X and Y axes thereof are inclined by 45 degrees with respect to the polarization plane 201 of the introduced incident light 101, the first polarization maintaining fiber 31 separates incident light 101 into the first linearly polarized wave propagating along the X axis and a second linearly polarized wave propagating along the Y axis, and propagates the first and second polarized lights. The amplitude of the first linearly polarized wave introduced into the X axis is equal to that of the second linearly polarized wave introduced into the Y axis.

Although the first polarization maintaining fiber 31 is a PANDA fiber, the first polarization maintaining fiber 31 may be other polarization maintaining fiber such as bow-tie fiber, elliptical jacket fiber and etc.

Fig. 2B is a diagram showing a connection relationship between the first and second polarization maintaining fibers 31 and 32. In FIG. 2B, the connection cross-section of the first polarization maintaining fiber 31 is indicated by a solid line, and the connection cross-section of the second polarization maintaining fiber 32 is indicated by a broken line.

The second polarization maintaining fiber 32 is a PANDA fiber similar to the first polarization maintaining fiber 31, and has a core 320, a pair of stressing portions 321 and 322 and a clad 324. Since configuration of the second polarization maintaining fiber 32 is similar to that of the first polarization maintaining fiber 31, a detailed description thereof will be omitted.

The second polarization maintaining fiber 32 is optically connected to the first polarization maintaining fiber 31 so that an X' axis and a Y' axis, i.e., a second phase advance axis and a second slow axis are inclined 45 degrees with respect to the X and Y axes, i.e., the phase advance and slow axes of the first polarization maintaining fiber 31. For example, the second polarization maintaining fiber 32 is connected to the first polarization maintaining fiber 31 by fused connection. The second polarization maintaining fiber 32 may be connected to the first polarization maintaining fiber 31 by a connection other than fused connection such as adhesive connection and etc.

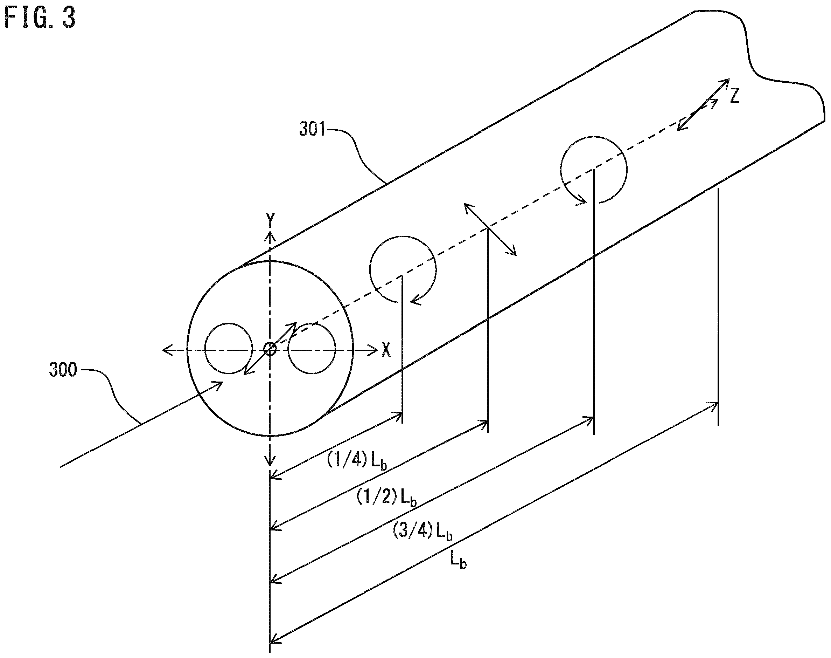

Fig. 3 is a diagram showing the relationship between the beat length Lb and the polarization state of the incident light 101 having polarization plane inclined 45 degrees with respect to the X and Y axes, i.e., a slow and phase advance axes of the polarization maintaining fiber.

The beat length Lb is a distance at which the phase difference between the first and second linearly polarized waves of the incident light 300 introduced into the polarization maintaining fiber 301 is 2n, i.e., is a distance at which the polarization state of the incident light 300 is returned to the linearly polarized wave inclined 45 degrees.

The incident light 300 introduced into the polarization maintaining fiber 301 transitions the polarization state while the incident light 300 propagates in the polarization maintaining fiber 301. The polarization state of the incident light 300 transitions from a linearly polarized wave to an elliptically polarized wave, and further transitions to a circularly polarized wave. The polarization state of the incident light 300 transitions from a circularly polarized wave to an elliptically polarized wave, and further transitions to a linearly polarized wave. The polarization state of the incident light 300 introduced into the polarization maintaining fiber 301 sequentially transitions among linearly polarized, elliptically polarized, circularly polarized, elliptically polarized and linearly polarized waves.

In particular, the polarization state of the incident light 300 is a right rotated circularly polarized wave at locations spaced by a quarter of the beat length Lb from the incident point. Further, the polarization state of the incident light 300 is a linearly polarized wave perpendicular to the polarization direction of the introduced incident light 300 at a location spaced bu a half of the beat length Lb from the incident point. Furthermore, the polarization state of the incident light 300 is a left rotated circularly polarized wave at a position spaced by three-quarters of the beat length Lb from the incident point. Then, the polarization state of the incident light 300 returns to a linearly polarized wave having polarization plane inclined by 45 degrees at a location that is spaced by the same length as the beat length Lb from the incident point.

$$J_{PMF,\alpha} = \begin{pmatrix} \cos\left(\frac{\pi}{L_b}L\right) + i\sin\left(\frac{\pi}{L_b}L\right)\cos 2\alpha & i\sin\left(\frac{\pi}{L_b}L\right)\sin 2\alpha \\ i\sin\left(\frac{\pi}{L_b}L\right)\sin 2\alpha & \cos\left(\frac{\pi}{L_b}L\right) - i\sin\left(\frac{\pi}{L_b}L\right)\cos 2\alpha \end{pmatrix} \quad (1)$$

Expression (1) shows a Jones matrix of the polarization maintaining fiber when the polarization plane of the incident light is incident by inclining $\alpha$ degrees with respect to each of the slow and the phase advance axis. In Expression (1), Lb indicates the beat length of the second polarization maintaining fiber 32, and L indicates the length of the polarization maintaining fiber.

In Expression (1), when the angle $\alpha$ of the introduced linearly polarized light is 45 degrees, and the length L of the polarization maintaining fiber is (1/4) Lb equal to that of the second polarization maintaining fiber 32, the Jones matrix of the polarization maintaining fiber is indicated as Expression (2).

$$J_{PMF,\pi/4} = \frac{1}{\sqrt{2}}\begin{pmatrix} 1 & i \\ i & 1 \end{pmatrix} \quad (2)$$

When the angle $\alpha$ of the introduced linearly polarized light shown in Expression (2) is 45 degrees, the Jones matrix of the second polarization maintaining fiber 32 matches the Jones matrix of the (1/4) wave plate. Since the Jones matrix shown in Expression (2) matches that of the (1/4) wave plate, the second polarization maintaining fiber 32 functions as a polarization conversion element that converts the polarization state of the incident light 101 introduced at an azimuth angle of 45 degrees from linearly polarized wave to circularly polarized wave, similarly to the (1/4) wave plate.

When the length L of the second polarization maintaining fiber 32 is one quarter of the beat length Lb of the second polarization maintaining fiber 32, the incident light 101 incident as linearly polarized light having 45 degrees inclined polarization plane is derived from the second polarization maintaining fiber 32 as circularly polarized light.

The length L of the second polarization maintaining fiber may be a length obtained by increasing the length of one quarter of the beat length from the length of 0 times and a positive integer multiple of the beat length Lb. Further, the length L of the second polarization maintaining fiber may be a length obtained by decreasing the length of one quarter of the beat length from a length of a positive integer multiple of the beat length Lb. When the length L of the second polarization maintaining fiber is any one of the above described lengths, the second polarization maintaining fiber may have functions similar to a (1/4) wave plate.

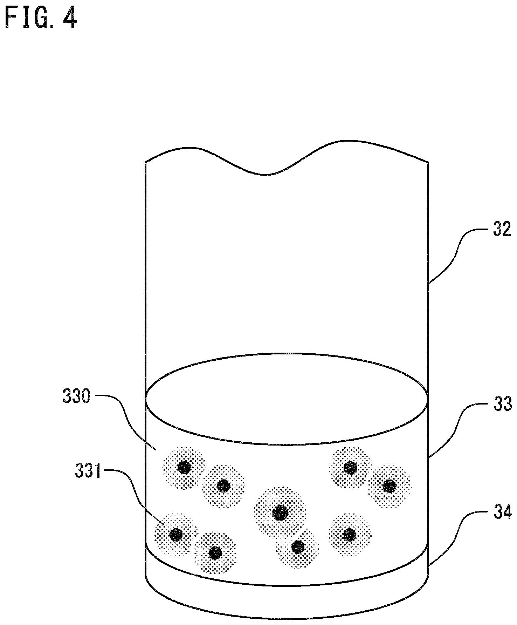

Fig. 4 is a schematic diagram of the Faraday rotator 33 and the mirror element 34.

The Faraday rotator 33 is a granular film having a dielectric 330 and nano-order magnetic particles 331 dispersed in the dielectric 330 in a stably phase separation from the dielectric 330, and is disposed on the end face of the second polarization maintaining fiber 32. Although oxide may be formed by the magnetic particles 331, for example, in a small portion of the outermost layer and etc., the magnetic particles 331 are dispersed alone in a thin film in the entire Faraday rotator 33 without making compounds with dielectric used as a binder. The distribution of the magnetic particles 331 in the Faraday rotator 33 may not be completely uniform, may be eccentrically located a little. If the dielectric 330 has high transparency and the magnetic particles 331 in the dielectric 330 has a size smaller than the wavelength of light, the Faraday rotator 33 has an optical transparency.

The faraday rotator 33 is not limited to a single layer, it may be a multilayer film in which the granular films and the dielectric films are alternately laminated. When the Faraday rotator 33 is formed by multi-layered granular films, multiple reflections are occurred in the granular films, and therefore a larger Faraday rotation angle is obtained.

The dielectric 330 is preferably fluoride (metallic fluoride) such as magnesium fluoride ($MgF_2$), aluminum fluoride ($AlF_3$), yttrium fluoride ($YF_3$) and etc. Further, the dielectric 330 may be an oxide such as tantalum oxide ($Ta_2O_5$), silicon dioxide ($SiO_2$), titanium dioxide ($TiO_2$), niobium pentoxide ($Nb_2O_5$), zirconium dioxide ($ZrO_2$), hafnium dioxide ($HfO_2$), aluminum trioxide ($Al_2O_3$) and etc. It is preferable that the dielectric 330 is formed by fluoride rather than oxide for good phase separation among the dielectric 330 and the magnetic particles 331, and it is more preferable that the dielectric 330 is formed by magnesium fluoride having a high transmittance.

The magnetic particle 331 may be formed by materials producing a Faraday effect, and is not limited, the magnetic particle 331 may be formed by ferromagnetic metals such as iron (Fe), cobalt (Co) and nickel (Ni) and alloys thereof. The examples of alloys of Fe, Co and Ni are for example, FeNi alloy, FeCo alloy, FeNiCo alloy and NiCo alloy. The Faraday rotation angle per unit length of Fe, Co and Ni is nearly two to three orders of magnitude larger than that of magnetic garnet applied to conventional Faraday rotators.

The mirror element 34 is formed on the Faraday rotator 33, and reflects the light transmitted through the Faraday rotator 33 to the Faraday rotator 33 to generate a return light 102. The mirror element 34 emits circularly polarized light to the Faraday rotator 30, and the rotation direction of the circularly polarized light is opposite to that of circularly polarized light transmitted through the magnetic field sensor element 30. For example, the mirror element 34 may be formed by silver (Ag) film, gold (Au) film, aluminum (Al) film, a dielectric multilayer film mirror and etc. An Ag film having high reflectivity and an Au film having high corrosion resistance are convenient for film formation and are preferable. The mirror element 34 may have any thickness that secures a sufficient reflective index of 98% or more, and for example, when the mirror element 34 is formed by an Ag film, it is preferable that the thickness is 50nm or more and 200nm or less. The Faraday rotation angle may be increased by reciprocating light in the Faraday rotator 33 using the mirror element 34.

The incident light 101 derived from the second polarization maintaining fiber 32 to the Faraday rotator 33 is transmitted through the Faraday rotator 33, and become the return light 102 transmitted through the Faraday rotator, by reflected by the mirror element 34. The return light 102 transmitted through the Faraday rotator 33 is introduced into the second polarization maintaining fiber 32.

The circularly polarized incident light 101 derived from the second polarization maintaining fiber 32 to the Faraday rotator 33 shifts a phase thereof in response to the magnetic field applied to the Faraday rotator 33. Further, the circularly polarized return light 102 reflected by the mirror element 34 shifts a phase thereof in response to the magnetic field applied to the Faraday rotator 33. The polarization plane of the return light 102 converted from circularly polarized light to linearly polarized light by the second polarization maintaining fiber 32 is rotated in response to the phase shifts of the incident light 101 and return light 102 transmitted through the Faraday rotator 33.

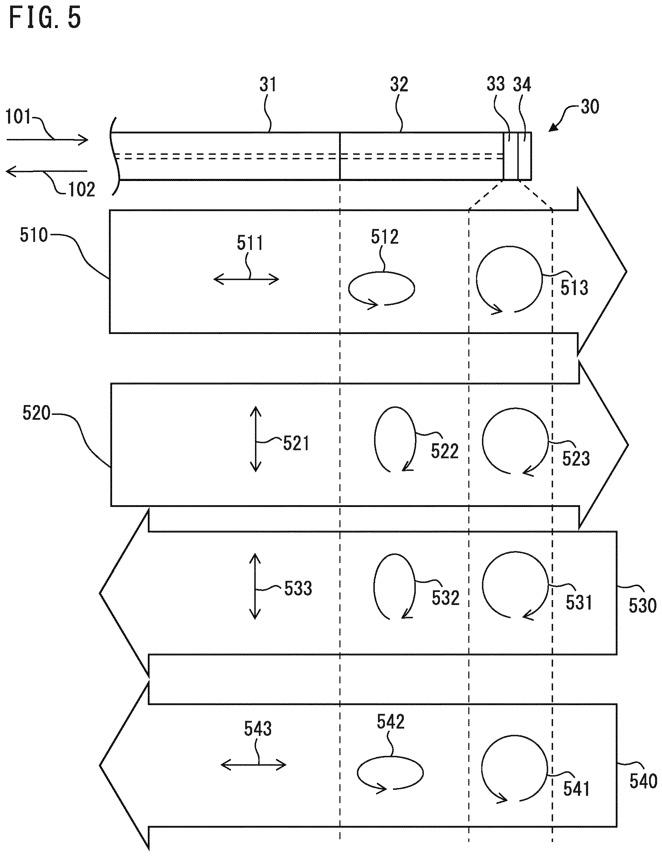

Fig. 5 is a diagram for explaining the polarization states of the incident light 101 derived from the magnetic field sensor element 30 and the return light 102 introduced into the magnetic field sensor element 30. In Fig. 5, no magnetic field is applied to the Faraday rotator 33, and phases of the incident light 101 and the return light 102 do not rotate, by transmitting through the Faraday rotator 33.

The incident light 101 introduced into the magnetic field sensor element 30 is separated into a first incident component 510 propagated along the first slow axis of the first polarization maintaining fiber 31, and a second incident component 520 propagated along the first phase advance axis, and propagates through the first polarization maintaining fiber 31. Thus, in the first polarization maintaining fiber 31, the polarization state of the first incident component 510 is a linearly polarized wave 511 parallel to the first slow axis, the polarization state of the second incident component 520 is a linear polarized wave 521 parallel to the first phase advance axis.

The polarization state of the first incident component 510 introduced from the first polarization maintaining fiber 31 to the second polarization maintaining fiber 32 is a left rotated elliptical polarized wave 512 in the second polarization maintaining fiber 32. Since the second polarization maintaining fiber 32 has a length of one quarter of the beat length Lb, the polarization state of the first incident component 510 derived from the second polarization maintaining fiber 32 is left rotated circularly polarized wave 513.

The polarization state of the second incident component 520 introduced from the first polarization maintaining fiber 31 to the second polarization maintaining fiber 32 is right rotated elliptical polarized wave 522 in the second polarization maintaining fiber 32. Since the second polarization maintaining fiber 32 has a length of one quarter of the beat length Lb, the polarization state of the second incident component 520 derived from the second polarization maintaining fiber 32 is a left rotated circularly polarized wave 523.

The first incident component 510 and the second incident component 520 derived from the second polarization maintaining fiber 32 as circularly polarized light are transmitted through the Faraday rotator 33 and are reflected by the mirror element 34. The return light 102 is generated when circularly polarized light derived from the second polarization maintaining fiber 32 is reflected by the mirror element 34. The polarization state of the first return component 530 corresponding to the first incident component 510 is inverted to a right rotated circularly polarized wave 531. Further, the polarization state of the second return component 540 corresponding to the second incident component 520 is inverted to a left rotated circularly polarized wave 541. The return light 102 generated by the mirror element 34 is transmitted through the Faraday rotator 33, and is introduced into the second polarization maintaining fiber 32.

The return light 102 introduced into the second polarization maintaining fiber 32 is separated into a first return component 530 propagated along the second phase advance axis of the second polarization maintaining fiber 31 and the second return component 540 propagated along the second slow axis, and propagates through the second polarization maintaining fiber 32 .

The polarization state of the first return component 530 introduced into the second polarization maintaining fiber 32 is a right rotated elliptically polarized wave 532 in the second polarization maintaining fiber 32. Since the second polarization maintaining fiber 32 has a length of one quarter of the beat length Lb, the polarization state of the first return component 530 derived from the second polarization maintaining fiber 32 is linearly polarized wave 533 parallel to the first phase advance axis of the first polarization maintaining fiber 31.

The polarization state of the second return component 540 introduced into the second polarization maintaining fiber 32 is a left rotated elliptical polarized wave 542 in the second polarization maintaining fiber 32. Since the second polarization maintaining fiber 32 has a length of one quarter of the beat length Lb, the polarization state of the second return component 540 derived from the second polarization maintaining fiber 32 is linearly polarized wave 543 parallel to the first slow axis of the first polarization maintaining fiber 31.

The return light 102 introduced into the first polarization maintaining fiber 31 is separated into a first return component 530 propagated along the first phase advance axis of the first polarization maintaining fiber 31 and a second return component 540 propagated along the first slow axis, and propagates through the first polarization maintaining fiber 31.

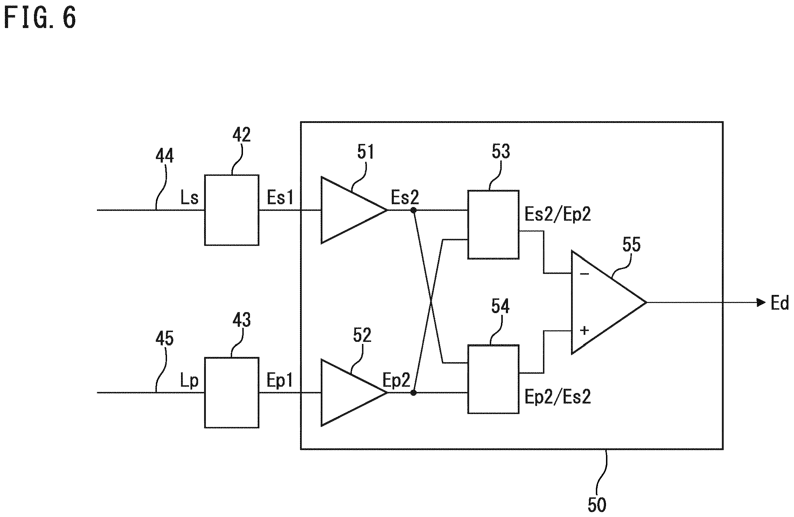

Fig. 6 is a circuit block diagram of the signal processor 50.

The signal processor 50 has a first amplifier circuit 51, a second amplifier circuit 52, a first divider circuit 53, a second divider circuit 54 and a differential amplifier circuit 55. The signal processor 50 detects optical intensity difference between the two polarization components photoelectrically converted from the electrical signal by the first light receiving element 42 and the second light receiving element 43, and convert from the detected value to a current value.

Each of the first amplifier circuit 51 and the second amplifier circuit 52 is an analog amplifier circuit formed by an operational amplifier and resistor elements and etc.

A first electric signal Es1 corresponding to the light amount Lp of the S polarization component 44 is input from the first light receiving element 42 to the first amplifier circuit 51, and the first amplifier circuit 51 amplifies the input first electric signal Es1 and outputs a first amplified electric signal Es2. The second electric signal Ep 1 corresponding to the light amount Lp of the P polarized component 45 is input from the second light receiving element 43 to the second amplifier circuit 52, and the second amplifier circuit 52 amplifies the input second electric signal Ep1 and outputs a second amplified electric signal Ep2.

Each of the first divider circuit 53 and the second divider circuit 54 is an analog divider circuit formed by an operational amplifier, resistors and etc.

The first divider circuit 53 divides the first amplified electric signal Es2 by the second amplified electric signal Ep2, and outputs a first analog signal (Es2/Ep2) indicating the divided output value to the negative input terminal of the differential amplifier circuit 55. The second dividing circuit 54 divides the second amplified electric signal Ep2 by the first amplified electric signal Es2, and outputs a second analog signal (Ep2/Es2) indicating the divided output value to the positive input terminal of the differential amplifier circuit 55.

For example, the differential amplifier circuit 55 is an operational amplifier, and outputs a detection signal Ed by differential amplifying a second analog signal (Ep2/Es2) input from the first analog signal (Es2/Ep2) and the second divider circuit 54 input from the first divider circuit 53.

(Effect of operation of the magnetic field sensor device according to the embodiment)

The magnetic field sensor device 1 may be formed by a single optical path, and may be easily manufactured, since a polarization maintaining fiber having visually recognizable optical axis is used as a polarization conversion element for converting from linearly polarized light to circularly polarized light, instead of the (1/4) wavelength plate having visually unrecognizable optical axis.

Further, in the magnetic field sensor device 1, the optical path lengths propagated by each component of the return light in the slow and phase advance axes of the polarization maintaining fiber may be equal, since the component propagating the slow axis in the incident light propagates the phase advance axis in the return light, and the component propagating the phase advance axis in the incident light propagates the slow axis in the return light. In particular, the first return component 530 corresponding to the first incident component 510 propagated along the first slow axis of the first polarization maintaining fiber 31 is propagated along the first phase advance axis of the first polarization maintaining fiber 31. On the other hand, the second return component 540 corresponding to the second incident component 520 propagated along the first phase advance axis of the first polarization maintaining fiber 31 is propagated along the first slow axis of the first polarization maintaining fiber 31.

In magnetic field sensor device 1, since the optical path lengths of the slow and phase advance axes propagated by each component of the return light is the equal, even if the fiber is distorted by environmental factors such as temperature change and curvature, and the optical path length of the slow axis is different from that of the phase advance axis, the optical path length of the components of the return light is equal. Since the optical path length of the components of the return light are not different each other by environmental factors, the accuracy of the magnetic field detection in magnetic field sensor device 1 may not be lowered due to the difference in the optical path length propagated by each component of the return light.

Further, since the magnetic field sensor device 1 uses the differential signal between the two components having equal optical path length as a detection signal indicating a detected magnetic field, even if the optical path length propagated by return light is changed by environmental factors, the accuracy of the magnetic field detection may not be lowered by the optical path length change.

Further, since the core diameter of the of the first polarization maintaining fiber 31 is equal to that of the second polarization maintaining fiber 32, and therefore no loss is occurred due to the difference of the core diameters, the efficiency of magnetic field detection in the magnetic field sensor device 1 may be high.

Further, in the magnetic field sensor device 1, since the first polarization maintaining fiber 31 and the second polarization maintaining fiber 32 are fused connected without a bonding member such as an adhesive, the optical path length is not changed by placing the bonding member, magnetic field may be detected with high accuracy.

**Claims**

1. A magnetic field sensor device comprising:

   a light emitter emitting linearly polarized light;
   a magnetic field sensor element introducing the linearly polarized light as incident light, and deriving return light in response to the incident light, wherein at least a portion thereof is disposed within a predetermined magnetic field;
   a detection signal generator separating the return light into S polarization component and P polarization component, and outputting a detection signal in response to magnetic field at which the magnetic field sensor element is disposed, based on the S and P polarization components; and
   an optical branching element transmitting the linearly polarized light to the magnetic field sensor element, and branching the return light to the detection signal generator, wherein the magnetic field sensor element comprising:

   a first polarization maintaining fiber separating the linearly polarized light into a first linearly polarized wave propagated along the first slow axis and a second linearly polarized wave propagated along the first phase advance axis faster than the first linearly polarized wave, and propagating the first linearly polarized wave and the second linearly polarized wave;
   a second polarization maintaining fiber having a second slow axis and a second phase advance axis, and connected to the first polarization maintaining fiber so that the second phase advance axis and the second slow axis are inclined 45 degrees with respect to the first phase advance axis and the first slow axis;
   a Faraday rotator optically connected to the second polarization maintaining fiber, and shifting a phase of circularly polarized light emitted from the second polarization maintaining fiber in response to magnetic field at which the magnetic field sensor element is disposed; and
   a mirror element connected to the Faraday rotator, and generating the return light.

2. The magnetic field sensor device according to claim 1, wherein a length of the second polarization maintaining fiber is a length obtained by increasing the length of one quarter of the beat length from the length of 0 times and a positive integer multiple of the beat length of the second polarization maintaining fiber.

3. The magnetic field sensor device according to claim 1, wherein a length of the second polarization maintaining fiber is a length obtained by decreasing the length of one quarter of the beat length from a length of a positive integer multiple of the beat length of the second polarization maintaining fiber.

4. The magnetic field sensor device according to any one of claims 1 to 3, wherein the first polarization maintaining fiber and the second polarization maintaining fiber are fused connected.

5. The magnetic field sensor device according to any one of claims 1 to 4, wherein each of the first polarization maintaining fiber and the second polarization maintaining fiber is a PANDA fiber.

6. A magnetic field sensor element comprising:

   a first polarization maintaining fiber separating the linearly polarized light into a first linearly polarized wave propagated along the first slow axis and a second linearly polarized wave propagated along the first phase advance axis faster than the first linearly polarized wave, and propagating the first linearly polarized wave and the second linearly polarized wave;
   a second polarization maintaining fiber having a second slow axis and a second phase advance axis, and connected to the first polarization maintaining fiber so that the second phase advance axis and the second slow axis are inclined 45 degrees with respect to the first phase advance axis and the first slow axis;
   a Faraday rotator optically connected to the second polarization maintaining fiber, and shifting a phase of circularly polarized light emitted from the second polarization maintaining fiber in response to magnetic field at which the magnetic field sensor element is disposed; and
   a mirror element connected to the Faraday rotator, and generating the return light.

FIG. 1

FIG. 2A

FIG. 2B

FIG. 3

FIG. 4

# FIG. 5

**FIG. 6**

## INTERNATIONAL SEARCH REPORT

| International application No. |
| --- |
| PCT/JP2019/034015 |

**A.   CLASSIFICATION OF SUBJECT MATTER**
Int. Cl. G01R33/032(2006.01)i, G02B6/02(2006.01)i, G02B6/024(2006.01)i, G02B6/42(2006.01)i, G02B27/14(2006.01)i, G02B27/28(2006.01)i

According to International Patent Classification (IPC) or to both national classification and IPC

**B.   FIELDS SEARCHED**

Minimum documentation searched (classification system followed by classification symbols)
Int. Cl. G01R33/032, G02B6/02, G02B6/024, G02B6/42, G02B27/14, G02B27/28

Documentation searched other than minimum documentation to the extent that such documents are included in the fields searched
Published examined utility model applications of Japan      1922-1996
Published unexamined utility model applications of Japan    1971-2019
Registered utility model specifications of Japan            1996-2019
Published registered utility model applications of Japan    1994-2019

Electronic data base consulted during the international search (name of data base and, where practicable, search terms used)

**C.   DOCUMENTS CONSIDERED TO BE RELEVANT**

| Category* | Citation of document, with indication, where appropriate, of the relevant passages | Relevant to claim No. |
| --- | --- | --- |
| Y | JP 07-111456 B2 (SUEDA, Tadashi) 29 November 1995, paragraphs [0009]-[0035], fig. 3 (Family: none) | 1-6 |
| Y | JP 2006-337519 A (NATIONAL INSTITUTE OF INFORMATION AND COMMUNICATIONS TECHNOLOGY) 14 December 2006, paragraphs [0029]-[0032], [0040], fig. 2 (Family: none) | 1-6 |
| A | US 2010/0141955 A1 (HUANG, Yong) 10 June 2010, entire text, all drawings (Family: none) | 1-6 |
| A | WO 2015/067293 A1 (OMNISENS SA) 14 May 2015, page 11, line 13 to line 20, fig. 2 (Family: none) | 1-6 |

☒   Further documents are listed in the continuation of Box C.      ☐   See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 08.10.2019 | 21.10.2019 |

| Name and mailing address of the ISA/ Japan Patent Office 3-4-3, Kasumigaseki, Chiyoda-ku, Tokyo 100-8915, Japan | Authorized officer |
| --- | --- |
| | Telephone No. |

Form PCT/ISA/210 (second sheet) (January 2015)

**INTERNATIONAL SEARCH REPORT**

| International application No. |
| --- |
| PCT/JP2019/034015 |

C (Continuation). DOCUMENTS CONSIDERED TO BE RELEVANT

| Category* | Citation of document, with indication, where appropriate, of the relevant passages | Relevant to claim No. |
| --- | --- | --- |
| A | JP 2012-053017 A (NATIONAL INSTITUTE OF INFORMATION AND COMMUNICATIONS TECHNOLOGY) 15 March 2012, entire text, all drawings (Family: none) | 1-6 |

Form PCT/ISA/210 (continuation of second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 7111456 A